(19) Europäisches Patentamt
European Patent Office
Office européen des brevets

(11) **EP 0 692 099 B1**

(12) **EUROPÄISCHE PATENTSCHRIFT**

(45) Veröffentlichungstag und Bekanntmachung des Hinweises auf die Patenterteilung:
**20.11.2002 Patentblatt 2002/47**

(21) Anmeldenummer: **95908896.4**

(22) Anmeldetag: **02.02.1995**

(51) Int Cl.⁷: $G01R\ 25/00$, $G01R\ 29/18$

(86) Internationale Anmeldenummer:
**PCT/EP95/00376**

(87) Internationale Veröffentlichungsnummer:
**WO 95/021385 (10.08.1995 Gazette 1995/34)**

(54) **PHASENPRÜFGERÄT**

PHASE TESTING DEVICE

APPAREIL DE CONTROLE DE PHASES

(84) Benannte Vertragsstaaten:
**AT BE CH DE DK ES FR GB GR IE IT LI LU MC NL PT SE**

(30) Priorität: **02.02.1994 DE 4403059**

(43) Veröffentlichungstag der Anmeldung:
**17.01.1996 Patentblatt 1996/03**

(73) Patentinhaber: **Pfisterer Kontaktsysteme GmbH & Co. KG**
**73650 Winterbach (DE)**

(72) Erfinder:
• **SCHUSTER, Martin**
**D-73733 Esslingen (DE)**

• **FISCHER, Gottfried**
**D-70599 Stuttgart (DE)**
• **GEORGI, Wolfgang**
**D-88250 Weingarten (DE)**

(74) Vertreter: **Patentanwälte Bartels und Partner**
**Lange Strasse 51**
**70174 Stuttgart (DE)**

(56) Entgegenhaltungen:
**DE-C- 4 403 059          FR-A- 2 230 116**
**FR-A- 2 621 698          JP-A- 52 006 571**
**US-A- 4 751 653**

**Beschreibung**

Die Erfindung betrifft ein einpoliges Phasenprüfgerät, insbesondere für Mittel und Hochspannungsnetze, mit den Merkmalen des Oberbegriffs des Anspruches 1.

Ein solches Phasenprüfgerät ist aus der JP-A-52 006 571 bekannt. Dabei wird mit Hilfe einer PLL-Schaltung (Phase Lock Loop) die Phasenlage der Spannung des zuerst kontaktierten Leiters über die Kontaktierzeit hinaus festgehalten und mittels einer Phasenvergleichsschaltung festgestellt, ob die Phasenlage der Spannung des zweiten Leiters vorlaufend, gleich oder nachlaufend ist, was der Benutzer aufgrund einer entsprechenden Anzeige erkennen kann. Anders als bei zweipoligen Phasenprüfgeräten kann die mit einem derartigen einpoligen Phasenprüfgerät durchgeführte Phasenprüfung mit erheblichen Fehlern behaftet sein.

Der Erfindung liegt das Problem zugrunde, ein einpoliges Phasenprüfgerät bereitzustellen, das die Nachteile des Standes der Technik überwindet und insbesondere trotz der einpoligen Ausbildung zuverlässig die Phasenlage zu prüfen vermag.

Das Problem ist durch das im Anspruch 1 bestimmte einpolige Phasenprüfgerät gelöst. Besondere Ausführungsarten der Erfindung sind in den Unteransprüchen bestimmt.

Bei der Phasenprüfung werden die Frequenzen der beiden Spannungen berücksichtigt und die Phasenprüfung wird abgebrochen, wenn die gemessenen Frequenzen außerhalb eines vorgegebenen Frequenzbereiches liegen.

Um die Frequenzen möglichst genau zu erfassen, ist es vorteilhaft, die Einrichtung der Prüfschaltung zur Frequenzbestimmung so auszubilden, daß sie selbsttätig eine mehrmalige Frequenzbestimmung in zeitlich vorbestimmten Abständen ausführt.

Bei einer bevorzugten Ausführungsform weist die Prüfschaltung nicht nur eine Einrichtung zur Frequenzbestimmung, sondern auch eine Einrichtung zur Bestimmung der Frequenzänderung sowohl während des Kontaktierens des ersten Leiters als auch des zweiten Leiters und zum Abbrechen der Phasenprüfung für den Fall auf, daß die Differenz der beiden Frequenzänderungsgeschwindigkeiten größer ist als ein vorgegebener Wert.

Weiterhin ist vorteilhafterweise auch eine Einrichtung zur Berechnung der den Zusammenhang zwischen der Zeit und der Frequenz angebenden Ausgleichsgeraden vorhanden.

Bei einer bevorzugten Ausführungsform enthält die Prüfschaltung einen Mikrocontroller, der die Funktionen der Simulationseinrichtung und der Vergleichseinrichtung ausführt.

Vorzugsweise weist die Prüfschaltung eine Eingangselektronik auf, welche an die Eingänge des Mikrocontrollers logische Signale für das Vorhandensein eines Spannungssignals der Prüfelektrode, der Versorgungsspannung für die Prüfschaltung und die Anzeigeeinrichtung sowie ein mit den Nulldurchgängen des von der Prüfelektrode erzeugten Spannungssignals synchronisiertes Rechtecksignal legt.

Um der internen Stromquelle nur dann Energie zu entnehmen, wenn eine Prüfung durchgeführt wird, wird zweckmäßigerweise ein manuell betätigbarer Schalter für den Anschluß der Prüfschaltung an die interne Stromquelle sowie eine Abschalteinrichtung vorgesehen, welche die Stromquelle abschaltet, wenn während einer vorbestimmten Zeitspanne am Eingang der Prüfschaltung kein Spannungssignal anliegt. Vorzugsweise führt der Mikrocontroller auch die Funktion der Abschalteinrichtung aus.

Mit Hilfe des Mikrocontrollers kann ferner auch die Funktionsfähigkeit des Phasenprüfgerätes getestet werden, was vor jeder Phasenprüfung notwendig ist. Zu diesem Zwecke kann der Mikrocontroller einen Speicher mit einem Testprogramm aufweisen, das durch ein Schließen des manuell betätigbaren Schalters abgerufen wird.

Die Funktionen aller dieser Einrichtungen kann der Mikrocontroller ebenfalls ausführen.

Im folgenden ist die Erfindung anhand eines in der Zeichnung dargestellten Ausführungsbeispiels im einzelnen erläutert. Es zeigen

Fig. 1    eine schematisch dargestellte Ansicht des Ausführungsbeispiels,

Fig. 2    eine Draufsicht auf die Unterseite des die elektronischen Bauteile enthaltenden Gehäuses,

Fig. 3    ein Blockschaltbild des Ausführungsbeispiels,

Fig. 4    ein Frequenz-Zeit-Diagramm zu den Frequenzmessungen,

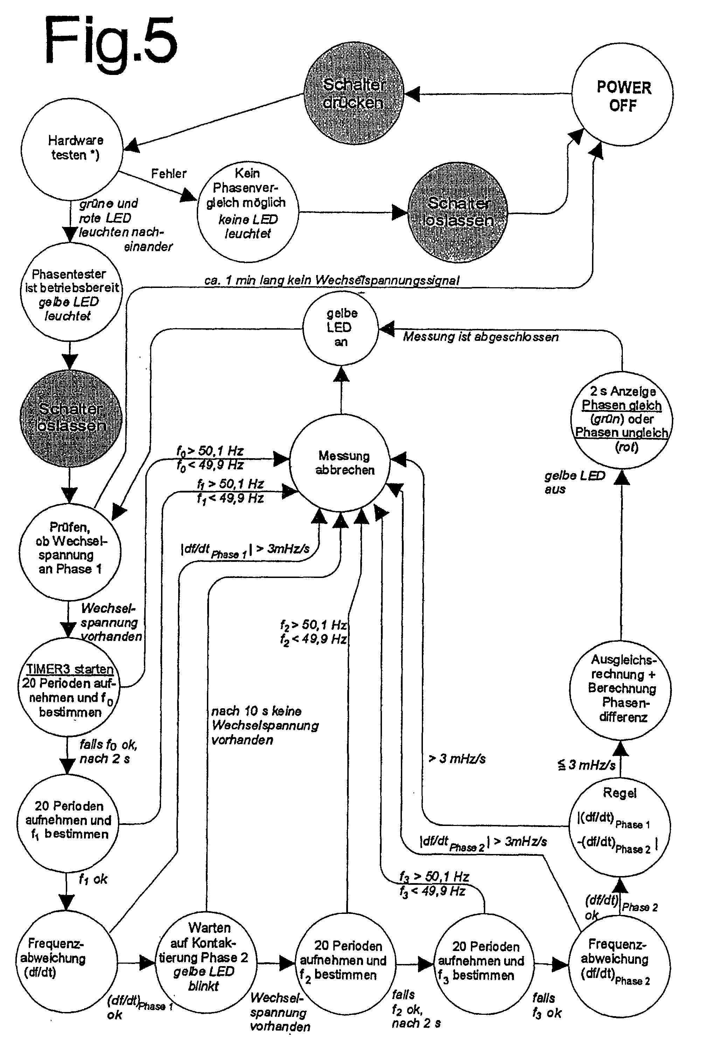

Fig. 5    das Zustandsdiagramm des Ausführungsbeispiels.

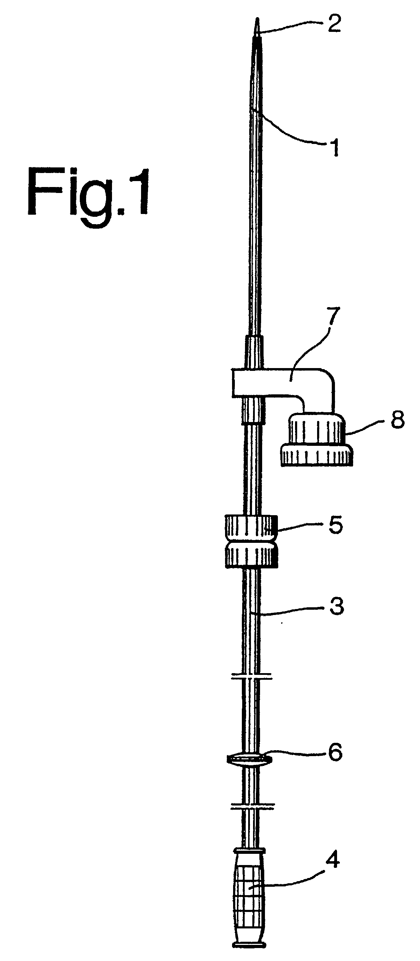

Ein Phasenprüfgerät für Mittel- und Hochspannungsnetze, mittels dessen festgestellt werden kann, ob die Spannungen zweier Leiter in einem solchen Netz gleichphasig oder verschiedenphasig sind, weist, wie Fig. 1 zeigt, am oberen Ende einer Selektivspitze 1, welche Störfeldeinschlüsse ausschaltet und in ihrem Inneren beispielsweise eine Sicherheits-Widerstandkette enthält, eine Prüfelektrode 2 auf, mittels deren die zu prüfenden Leiter kontaktiert werden. An das untere Ende der Selektivspitze 1 kann eine Isolierstange 3 angekuppelt werden, deren unteres Ende einen Isoliergriff 4 trägt. Zwei Schirme 5 und 6 sind so auf der Isolierstange 4 angeordnet, daß sie den Schutzabstand bzw. den Bereich kennzeichnen, der nicht übergriffen werden darf.

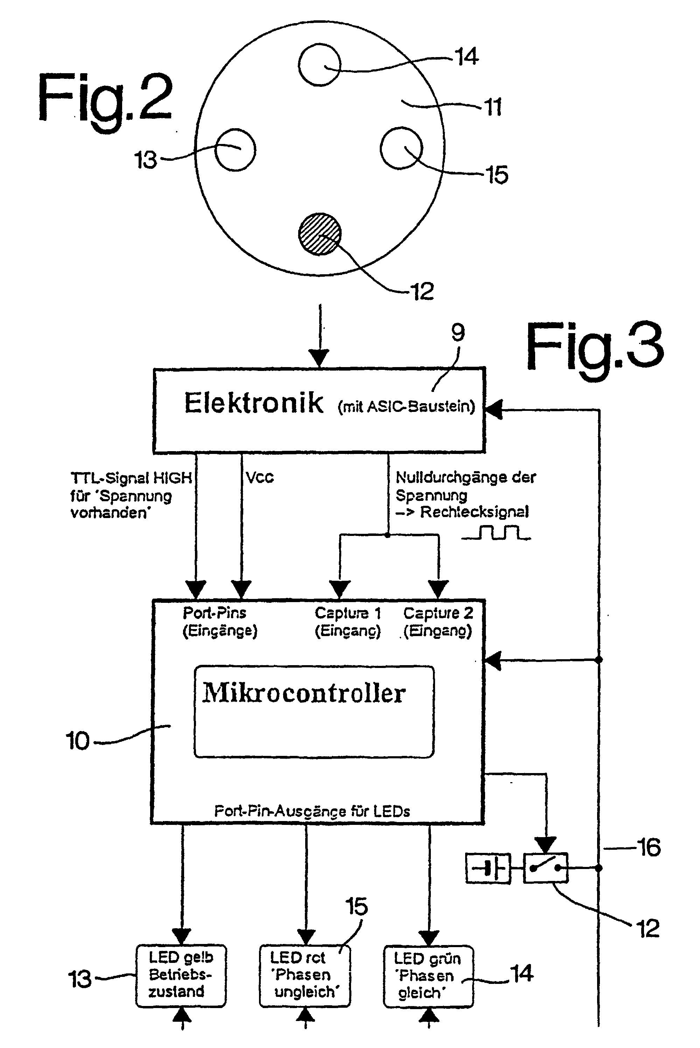

Im Bereich des unteren Endes der Selektivspitze 1 ist an dieser ein radial abstehender Tragarm 7 festgelegt, dessen nach unten abgewinkelter Endabschnitt ein Gehäuse 8 trägt. In diesem Gehäuse sind, wie Fig. 3 zeigt, eine mit dem unteren Ende der Sicherheits-Widerstandkette elektrisch verbundene Eingangselektronik 9, ein Mikrocontroller 10 und eine Batterie enthalten.

Eine die Unterseite des Gehäuses 8 bildende Frontplatte 11 (Fig. 2) trägt einen manuell betätigbaren Schalter 12 sowie eine gelbe Leuchtdiode 13, eine grüne Leuchtdiode 14 und eine rote Leuchtdiode 15. Mittels des Schalters 12 können die Eingangselektronik 9, der Mikrocontroller 10 und die drei Dioden mit der Batterie verbunden werden. Der Schalter 12 ist auch elektronisch ansteuerbar, damit er vom Mikrocontroller 10 in seinen nichtleitenden Zustand gebracht werden kann.

Die Eingangselektronik 9 erzeugt aufgrund des Spannungssignals der Prüfelektrode 2 ein logisches Eins-Signal, sofern der mittels der Prüfelektrode 2 kontaktierte Leiter Spannung führt. Ferner erzeugt die Eingangselektronik 9 ein logisches Eins-Signal, wenn die Versorgungsspannung der Batterie für einen ordnungsgemäße Betrieb des Phasenprüfgerätes ausreicht. Schließlich erzeugt die Eingangselektronik 9 aufgrund der Nulldurchgänge der von der Prüfspitze gelieferten Spannung ein Rechtecksignal. Dieses Rechtecksignal wird, wie Fig. 3 zeigt, an zwei Eingänge des Mikrocontrollers 10 angelegt. Zwei andere Eingänge sind mit den Ausgängen der Eingangselektronik 9 für die beiden logischen Signale verbunden. Die Leuchtdioden 13 bis 15 sind mit je einem der Ausgängs des Mikrocontrollers 10 verbunden. Ein anderer Ausgang führt zu dem Schalter 12.

Durch das manuelle Einschalten des Schalters 12 wird zunächst ein Funktionstest durchgeführt. Zu diesem Zwecke wird aus einem Speicher des Mikrocontrollers 10 ein Testprogramm abgerufen. Die gelbe Leuchtdiode 13 leuchtet auf, wenn das im folgenden als Phasentester bezeichnete Phasenprüfgerät voll funktionsfähig und betriebsbereit ist. Das Aufleuchten der gelben Leuchtdiode 13 stellt auch die Aufforderung an den Benutzer des Phasentesters dar, den ersten Leiter mit der Prüfelektrode 2 zu kontaktieren. Führt der erste Leiter eine Wechselspannung, dann erzeugt die Eingangselektronik 9 ein logisches Eins-Signal. Außerdem erzeugt sie die bereits erwähnte Rechteckspannung, deren ansteigende Flanken mit dem Nulldurchgang von der negativen zur positiven Halbwelle und deren fallende Flanken mit dem Nulldurchgang von der positiven zur negativen Halbwelle synchronisiert sind. Ist die Prüfung, ob der Leiter eine Wechselspannung führt, abgeschlossen, dann wird ein Timer gestartet, der die Zeitdauer für zwanzig Perioden der Wechselspannung ermittelt, aufgrund deren die Frequenz $f_0$ bestimmt wird. Ist diese Frequenz $f_0$ größer als 50,1 Hz oder kleiner 49,9 Hz dann bricht der Mikrocontroller 10 die ganze Messung ab. Die gelbe Leuchtdiode 13, die zu Beginn der Kontaktierung des ersten Leiters erloschen ist, leuchtet nun wieder auf. Liegt hingegen die Frequenz $f_0$ innerhalb

des genannten Frequenzbereiches, dann wird zwei Sekunden nach Beendigung der ersten Frequenzmessung eine zweite Frequenzmessung durchgeführt. Auch hier wird aus der Zeitdauer von zwanzig Perioden die Frequenz $f_1$ bestimmt. Auch diese Frequenz wird daraufhin vom Mikrocontroller 10 geprüft, ob sie außerhalb oder innerhalb des zulässigen Frequenzbereiches liegt. Im erstgenannten Fall bricht der Mikrocontroller 10 die Messung ab, im zweitgenannten Fall wird die gegebenenfalls vorhandene Frequenzänderung bestimmt. Ist sie größer als 3 mHz pro Sekunde, dann bricht der Mikrocontroller 10 die Messung ab. Liegt sie innerhalb dieses Wertes, dann beginnt die gelbe Leuchtdiode 13 zu blinken, was die Aufforderung an den Benutzer darstellt, nunmehr den zweiten Leiter zu kontaktieren.

Während der Kontaktierung des ersten Leiters wird der Verlauf von dessen Wechselspannung zumindest hinsichtlich der Nulldurchgänge vom Mikrocontroller 10 nachgebildet. Diese Nachbildung wird durch Simulation auch nach Beendigung der Kontaktierung fortgeführt.

Nachdem die Bestimmung der Frequenz der Spannung des ersten Leiters sowie deren Frequenzänderung abgeschlossen ist, wird die Bedienungsperson durch ein Blinken der gelben Leuchtdiode 13 aufgefordert, den zweiten Leiter zu kontaktieren. Erfolgt diese Kontaktierung nicht innerhalb einer vorgegebenen Zeit-Spanne, die im Ausföhrungsbeispiel 10 Sek beträgt, wird die Messung abgebrochen. Erfolgt die Kontaktierung innerhalb der vorgegebenen Zeitspanne und führt der zweite Leiter eine Wechselspannung, dann wird wie bei dem ersten Leiter zweimal im Abstand von 2 Sek die Frequenz aus der Zeitdauer von zwanzig Perioden bestimmt. Außerdem wird geprüft, ob die gemessene Frequenz innerhalb des zulässigen Frequenzbereiches liegt. Ebenso wird die Frequenzänderung bestimmt und mit dem zulässigen Grenzwert verglichen.

Wenn bis zu diesem Zeitpunkt die Prüfung ordnungsgemäß durchgeführt werden konnte, wird überprüft, ob die Differenz aus der Frequenzänderung der Spannung des ersten Leiters und der Frequenzänderung der Spannung des zweiten Leiters gleich oder kleiner 3 mHz/s ist. Wird diese Bedingung nicht eingehalten, dann wird die Messung abgebrochen. Im Fall der Einhaltung wird vom Mikrocontroller 10 zunächst eine vereinfachte Ausgleichsrechnung durchgeführt. Mit

$$t_0{}^* = \frac{t_{11} + t_{02}}{2}, \; f_0{}^* = \frac{f_0 + f_1}{2}, \; t_1{}^* = \frac{t_{31} + t_{22}}{2}, \; f_1{}^* = \frac{f_2 + f_3}{2}$$

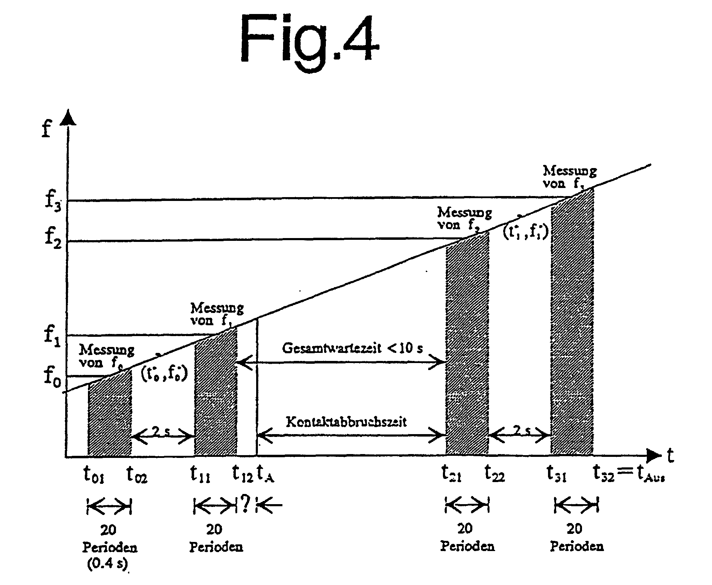

wobei $f_0$ bis $f_3$ die bei den vier aufeinander folgenden Frequenzmessungen ermittelten Frequenzen und $t_{11}$, $t_{02}$, $t_{31}$ sowie $t_{22}$ die in dem Diagramm gemäß Fig. 4 angegebenen Zeiten bedeuten, wird für die Abhängigkeit der Frequenz von der Zeit folgende Gleichung gebildet

$$f = \frac{f_1{}^* - f_0{}^*}{t_1{}^* - t_0{}^*} (t - t_0{}^*) + f_0{}^*$$

die auch als Ausgleichsgerade bezeichnet wird.

Mit der Annahme, daß eine lineare Frequenzänderung gemäß dieser Gleichung aufgetreten ist, wird dann vom Mikrocontroller 10 aufgrund der Phasenlage der von ihm beispielsweise mit Hilfe eines Schwingkreises simulierten Wechselspannung des ersten Leiters und der Phasenlage der Spannung des zweiten Leiters die Phasenverschiebung bestimmt. Ist diese Phasenverschiebung kleiner als ein vorgegebener Grenzwert, der im Ausführungsbeispiel 30° beträgt, dann leuchtet die grüne Leuchtdiode 14 auf, weil dann davon ausgegangen werden kann, daß die beiden Leiter der gleichen Phase des Netzes zugehören. Ist die Phasenverschiebung jedoch größer als der Grenzwert, dann leuchtet die rote Leuchtdiode 15 auf als Zeichen dafür, daß die beiden Leiter unterschiedlichen Phasen des Netzes zugehören. Nach zwei Sekunden wird diese Anzeige beendet. Es leuchtet dann wieder die gelbe Leuchtdiode 13 auf, zum Zeichen dafür, daß die nächste Prüfung durchgeführt werden kann. Sofern innerhalb von einer Minute nicht wieder ein Wechselspannungssignal am Eingang des Mikrocontrollers 10 anliegt, wird der Schalter 12 geöffnet.

## Patentansprüche

1. Einpoliges Phasenprüfgerät, insbesondere für Mittel- und Hochspannungsnetze, mit einer einzigen Prüfelektrode (2), deren Spannungssignal am Eingang einer Prüfschaltung (9, 10) anliegt, die an eine interne Stromquelle anschließbar ist und eine Simulationseinrichtung für die Phasenlage der Spannung eines zuerst kontaktierten ersten Leiters über die Kontaktzeit hinaus sowie eine Vergleichseinrichtung aufweist, welche die von der Simulationseinrichtung zur Verfügung gestellte Phasenlage der Spannung des zuerst kontaktierten Leiters mit der Phasenlage der Spannung eines zweiten kontaktierten Leiters vergleicht und ein auf diesem Vergleich beruhendes Signal an eine Anzeigeeinrichtung (13 bis 15) überträgt,
   **gekennzeichnet durch** eine Einrichtung der Prüfschaltung (9, 10) zur Frequenzbestimmung sowohl während der Kontaktierung des ersten Leiters als auch des zweiten Leiters und zum Abbrechen der Phasenprüfung für den Fall, daß die gemessenen Frequenzen außerhalb eines vorgegebenen Frequenzbereiches liegen.

2. Phasenprüfgerät nach Anspruch 1, **dadurch gekennzeichnet, daß**
   die Einrichtung der Prüfschaltung (9, 10) zur Frequenzbestimmung für eine selbsttätige, mehrmalige Frequenzbestimmung in zeitlich vorbestimmtem Abstand ausgebildet ist.

3. Phasenprüfgerät nach Anspruch 1 oder 2, **gekennzeichnet durch** eine Einrichtung der Prüfschaltung (9, 10) zur Bestimmung der Frequenzänderung sowohl während der Kontaktierung des ersten Leiters als auch des zweiten Leiters und zum Abbrechen der Phasenprüfung für den Fall, daß die Differenz der beiden Frequenzänderungsgeschwindigkeiten größer ist als ein vorgegebener Wert.

4. Phasenprüfgerät nach einem der Ansprüche 1 bis 3, **gekennzeichnet durch** eine Einrichtung zur Berechnung der den Zusammenhang zwischen der Zeit und der Frequenz ergebenden Ausgleichsgeraden aufgrund von gemessenen Frequenzen.

5. Phasenprüfgerät nach einem der Ansprüche 1 bis 4, **dadurch gekennzeichnet, daß** die Prüfschaltung (9, 10) einen Mikrocontroller (10) aufweist, der die Simulationseinrichtung und die Vergleichseinrichtung bildet.

6. Phasenprüfgerät nach Anspruch 5, **dadurch gekennzeichnet, daß** die Prüfschaltung (9, 10) eine Eingangselektronik (9) aufweist, welche an die Eingänge des Mikrocontrollers (10) logische Signale für das Vorhandensein eines Spannungssignals der Prüfelektrode (2), der Versorgungsspannung für die Prüfschaltung (9, 10) und die Anzeigeeinrichtung (13 bis 15) sowie ein mit den Nulldurchgängen des Spannungssignals synchronisiertes Rechtecksignal legt.

7. Phasenprüfgerät nach einem der Ansprüche 1 bis 6, **gekennzeichnet durch** einen manuell betätigbaren Schalter (12) für den Anschluß der Prüfschaltung (9, 10) an die interne Stromquelle (16) sowie eine Abschalteinrichtung, welche die Stromquelle (16) abschaltet, wenn während einer vorbestimmten Zeitspanne am Eingang der Prüfelektrode (2) kein Spannungssignal anliegt.

8. Phasenprüfgerät nach Anspruch 7, **dadurch gekennzeichnet, daß** der Mikrocontroller (10) auch die Abschalteinrichtung bildet.

9. Phasenprüfgerät nach Anspruch 7, **gekennzeichnet durch** einen Speicher des Mikrocontrollers (10), aus dem **durch** ein Schließen des manuell betätigbaren Schalters (12) ein Selbsttestprogramm abrufbar ist.

10. Phasenprüfgerät nach einem der Ansprüche 5 bis 9, **dadurch gekennzeichnet, daß** der Mikrocontroller (10) auch die Einrichtungen zur Frequenzbestimmung, zur Bestimmung der Frequenzänderungsgeschwindigkeit und zur Berechnung der Ausgleichsgeraden bildet.

**Claims**

1. Single-pole phase-testing device, especially for medium-voltage and high-voltage networks, having a single testing electrode (2), the voltage signal of which is present at the input of a test circuit (9, 10) which is connectable to an internal current source and which has a simulator for simulating the phase position of the voltage of a first-contacted first conductor beyond the contact time and a comparator which compares the phase position, made available by the simulator, of the voltage of the first-contacted conductor with the phase position of the voltage of a second contacted conductor and transmits a signal based on that comparison to a display device (13 to 15), **characterised by** a device of the test circuit (9, 10) for frequency determination during the contacting of both the first conductor and the second conductor and for discontinuing phase testing if the measured frequencies lie outside a specified frequency range.

2. Phase-testing device according to claim 1, **characterised in that** the device of the test circuit (9, 10) for frequency determination is constructed for automatic repeated frequency determination at predetermined time intervals.

3. Phase-testing device according to claim 1 or 2, **characterised by** a device of the test circuit (9, 10) for determining the change in frequency during the contacting of both the first conductor and the second conductor and for discontinuing phase testing if the difference between the two frequency change rates is greater than a specified value.

4. Phase-testing device according to any one of claims 1 to 3, **characterised by** a device for calculating the mean straight lines, which give the connection between the time and the frequency, on the basis of measured frequencies.

5. Phase-testing device according to any one of claims 1 to 4, **characterised in that** the test circuit (9, 10) has a microcontroller (10) which forms the simulator and the comparator.

6. Phase-testing device according to claim 5, **characterised in that** the test circuit (9, 10) has an electronic input system (9) which applies to the inputs of the microcontroller (10) logic signals indicative of the presence of a voltage signal of the testing electrode (2) and the supply voltage for the test circuit (9, 10) and for the display device (13 to 15), and also a rectangular signal synchronised with the zero crossings of the voltage signal.

7. Phase-testing device according to any one of claims 1 to 6, **characterised by** a manually operable switch (12) for connecting the test circuit (9, 10) to the internal current source (16), and a switch-off device which switches off the current source (16) when, for a predetermined period of time, no voltage signal is present at the input of the testing electrode (2).

8. Phase-testing device according to claim 7, **characterised in that** the microcontroller (10) also forms the switch-off device.

9. Phase-testing device according to claim 7, **characterised by** a memory of the microcontroller (10), from which memory a self-test program can be retrieved by closing the manually operable switch (12).

10. Phase-testing device according to any one of claims 5 to 9, **characterised in that** the microcontroller (10) also forms the devices for determining the frequency, for determining the frequency change rate and for calculating the mean straight lines.

**Revendications**

1. Appareil de contrôle de phases unipolaire, en particulier pour les réseaux moyenne tension et haute tension, comprenant une seule électrode de contrôle (2), dont le signal de tension est transmis vers l'entrée d'un circuit de contrôle (9, 10), qui peut être raccordé à une source de courant interne et comporte une unité de simulation pour la position de phase de la tension d'un premier conducteur à contacter en premier, au-delà du temps de contact, ainsi qu'un comparateur, qui compare la position de phase de la tension du conducteur à contacter en premier, mise à disposition par l'unité de simulation, avec la position de phase de la tension d'un deuxième conducteur contacté et transmet un signal fondé sur cette comparaison vers une unité d'affichage (13 à 15),
**caractérisé par** une unité du circuit de contrôle (9, 10) destinée à déterminer les fréquences pendant la mise en contact non seulement du premier conducteur, mais aussi du deuxième conducteur et destinée à interrompre le contrôle de phases au cas où les fréquences mesurées se situeraient en dehors d'une plage de fréquences prédéfinie.

2. Appareil de contrôle de phases selon la revendication 1, **caractérisé en ce que** l'unité du circuit de contrôle (9, 10) destinée à déterminer les fréquences est conçue pour une détermination automatique et répétitive des fréquences, dans des intervalles de temps prédéfinis.

3. Appareil de contrôle de phases selon la revendication 1 ou 2, **caractérisé par** une unité du circuit de contrôle (9, 10) destinée à déterminer la variation des fréquences pendant la mise en contact non seulement du premier conducteur, mais aussi du deuxième conducteur et destinée à interrompre le contrôle de phases au cas où la différence des deux vitesses de variation des fréquences serait supérieure à une valeur prédéfinie.

4. Appareil de contrôle de phases selon une des revendications 1 à 3, **caractérisé par** une unité destinée à calculer, en se basant sur les fréquences mesurées, les droites de compensation, desquelles résulte la corrélation entre le temps et la fréquence.

5. Appareil de contrôle de phases selon une des revendications 1 à 4, **caractérisé en ce que** le circuit de contrôle (9, 10) comporte un microcontrôleur (10), qui constitue l'unité de simulation et le comparateur.

6. Appareil de contrôle de phases selon la revendication 5, **caractérisé en ce que** le circuit de contrôle (9, 10) comporte un composant électronique d'entrée (9), qui transmet vers les entrées du microcontrôleur (10) des signaux logiques pour la présence d'un signal de tension de l'électrode de contrôle (2), de la tension d'alimentation pour le circuit de contrôle (9, 10) et l'unité d'affichage (13 à 15), ainsi qu'un signal rectangulaire synchronisé avec les passages par zéro du signal de tension.

7. Appareil de contrôle de phases selon une des revendications 1 à 6, **caractérisé par** un commutateur (12) à actionner manuellement, destiné à connecter le circuit de contrôle (9, 10) à la source de courant interne (16), ainsi qu'une unité de déconnexion, qui déconnecte la source de courant (16) si aucun signal de tension n'a été capté pendant un intervalle de temps prédéfini à l'entrée de l'électrode de contrôle (2).

8. Appareil de contrôle de phases selon la revendication 7, **caractérisé en ce que** le microcontrôleur (10) forme aussi l'unité de déconnexion.

9. Appareil de contrôle de phases selon la revendication 7, **caractérisé par** une mémoire du microcontrôleur (10), qui contient un programme d'autotest qui peut être chargé à la suite d'une fermeture du commutateur (12) à actionner manuellement.

10. Appareil de contrôle de phases selon une des revendications 5 à 9, **caractérisé en ce que** le microcontrôleur (10) forme également les unités destinées à déterminer les fréquences, à déterminer la vitesse de variation des fréquences et à calculer les droites de compensation.

# Fig.1

# Fig.2

14
11
13
15
12

# Fig.3

9

**Elektronik** (mit ASIC-Baustein)

TTL-Signal HIGH | Vcc | Nulldurchgänge der
für 'Spannung | | Spannung
vorhanden' | | –> Rechtecksignal

Port-Pins | Capture 1 | Capture 2
(Eingänge) | (Eingang) | (Eingang)

**Mikrocontroller**

10

Port-Pin-Ausgänge für LEDs

16

12

15

LED gelb
Betriebszustand

LED rot
'Phasen
ungleich'

LED grün
'Phasen
gleich'

13

14

# Fig.4

# Fig.5